# EUROPEAN PATENT SPECIFICATION

(11) **EP 4 537 119 B1**
(45) Date of publication and mention of the grant of the patent: **15.04.2026**
(21) Application number: 23728082.1
(22) Date of filing: 23.05.2023
(51) Int. Cl.: G01R 31/34, G01R 27/02

(54) **A MONITORING DEVICE, A SYSTEM AND A METHOD FOR MONITORING INSULATION CONDITION OF A MOTOR**
ÜBERWACHUNGSVORRICHTUNG, SYSTEM UND VERFAHREN ZUR ÜBERWACHUNG DES ISOLATIONSZUSTANDS EINES MOTORS
DISPOSITIF DE SURVEILLANCE, SYSTÈME ET PROCÉDÉ DE SURVEILLANCE D'ÉTAT D'ISOLATION D'UN MOTEUR

(30) Priority: 13.06.2022 FI 20225527
(43) Date of publication of application: 16.04.2025
(73) Proprietor: Talas Electric Oy, 30100 Forssa (FI)
(72) Inventor: HALONEN, Ville, 00430 Helsinki (FI)
(74) Representative: Berggren Oy
(86) International application number: PCT/FI2023/050287
(87) International publication number: WO 2023/242467

(56) References cited:
- CN-A- 105 158 659
- CN-A- 113 138 308
- CN-A- 113 376 482
- US-B1- 9 664 716

## Description

### Technical field

The invention relates to electric motor condition monitoring. More specifically, the invention relates to a monitoring device for monitoring winding insulation condition of a motor connected to a variable frequency drive. The invention also concerns a system and a method for monitoring winding insulation condition of a motor with the system, where the system comprises a monitoring device and a variable frequency drive.

### Background

Electric motors often operate in humid conditions or face risk of exposure to floods. For example, pulp, paper and saw mills have several process areas such as pulp dryer, wet end and drying areas where electric motors are operating in humid conditions. Moreover, many industrial facilities have pumping stations which can be located underground, inside a humid cave or outside in varying humidity conditions. Another example is process facilities such as rolling mills and concentrator plants that typically have humid process areas with many electric motors. Mines, windmills and offshore applications requiring electric motors are some further examples of electric motors operating in humid conditions.

Flooding, humidity, rapid temperature changes, as well as increase in temperature due to dust deposits lower the insulation resistance, which can deteriorate winding insulation condition of an electric motor, eventually causing motor failure. In particular, a large fraction of all motor failures tend to be caused by winding short circuit.

A common way to address the problem of motor failure is based on overcurrent protection of a variable frequency drive that drives the motor and double securing critical electric motors by having a spare motor to replace a failed motor. Since electric motors are commonly controlled by variable frequency drives, typically capable of automatic current measurement, electronic short circuit protection can be activated when the current to the motor starts to exceed the maximum current provided by the variable frequency drive. However, the variable frequency drive overcurrent protection is only activated when the insulation is already in very bad condition and the motor cannot be used anymore, thus resulting in a sudden shut down of the process. The motor is then stopped and either changed or cleaned and dried manually. The problem with such approach is that it requires manual replacement or drying of the motor, which is time consuming and challenging in many cases since electric motors are often located in places that are hard to access and may cause risk of accident to workers. Furthermore, such approach leads to unexpected downtimes and increased maintenance costs as well as could require more space and upfront investment for keeping a larger number of spare parts available.

Another known approach for reducing motor failures in harsh conditions includes equipping the motors with anticondensation heating, which maintains the temperature inside the motor a few degrees higher than the surrounding air temperature. However, such anticondensation heating is typically continuously on even when the winding insulation condition is excellent, thus leading to high energy consumption.

Furthermore, insulation resistance measurement devices that apply voltage for measuring the resistance are also known. Such resistance measurement devices, however, increase energy consumption by the device.

A monitoring device for monitoring winding insulation condition of an electric motor, motor phases of which are connected to a variable frequency drive is disclosed in document CN 105 158 659 A.

### Summary

An object of the present invention is to provide an alternative and improved monitoring device for monitoring winding insulation condition of a motor connected to a variable frequency drive. The characterizing features of the monitoring device according to the invention are given in claim 1. Another object of the invention is to provide an improved system and a method for monitoring winding insulation condition of a motor. The characterizing features of the system and the method according to the invention are given in the other independent claims.

The monitoring device according to the invention for monitoring winding insulation condition of an electric motor, motor phases of which are connected to a variable frequency drive, is configured, such as by standby mode determining means or a processing unit, to receive or obtain a signal indicative of a standby mode of the variable frequency drive. The monitoring device according to the invention is further configured to measure, e.g., by a voltage measuring circuit being optionally partly external and partly internal with respect to the monitoring device, a standby voltage, being applied by the variable frequency drive during the standby mode, between at least one of the motor phases and the frame, and/or the grounding terminal or potential, of the motor while the variable frequency drive is determined to be in the standby mode, the standby voltage being indicative of the winding insulation condition. The monitoring device according to the invention thus does not apply a voltage for measurement of winding insulation condition.

The current invention further discloses a system according to the invention for monitoring winding insulation condition of a motor, motor phases of which are connected to a variable frequency drive. The system according to the invention comprises the monitoring device defined above and connected to or comprised within the variable frequency drive for receiving or obtaining a signal indicative of the standby mode, and the variable frequency drive configured to be connected to the motor phases of the motor, wherein the monitoring device is configured to be connected to at least one of the motor phases as well as to the frame, and/or the grounding terminal or potential, of the motor to measure the standby voltage applied by the variable frequency drive between the at least one of the motor phases of the motor and the frame of the motor when the variable frequency drive is in the standby mode.

The current invention further discloses a method according to the invention for monitoring winding insulation condition of a motor, motor phases of which are connected to a variable frequency drive. The method according to the invention comprises receiving or obtaining, by a monitoring device, such as defined above, a signal indicative of a standby mode of the variable frequency drive, and measuring a standby voltage, being applied by the variable frequency drive during the standby mode, between at least one of the motor phases and the frame, and/or the grounding terminal or potential, of the motor with the monitoring device, while the variable frequency drive is determined to be in the standby mode, the standby voltage being indicative of the winding insulation condition of the motor.

The monitoring device, the system and the method of the invention enable monitoring of the winding insulation condition of a motor in order to make predictions for maintenance needs, thus enabling predictive maintenance and reducing downtime of equipment and especially sudden and unexpected downtimes, at the same time reducing the amount and difficulty of manual labour. The monitoring device, the system and the method of the invention provide a time efficient monitoring of the winding insulation condition of a motor with easy access to the standby voltage values. Designing the measurement of the standby voltage to be carried out between at least one of the motor phases and the frame, and/or the grounding terminal or potential, i.e., at the output of the variable frequency drive provides versatile means for monitoring winding insulation condition of an electric motor that is easy to apply, since variable frequency drive output is easily accessible. In particular, since the measurement can be carried out at the variable frequency drive output, no modification to the variable frequency drive, nor access to the internal parts of the variable frequency drive is necessary.

The standby mode of a variable frequency drive is defined as a mode where the variable frequency drive is supplied with power from an electrical energy source, such as the grid or a battery or other power supply, to be ready for operation, that is, for rotating or at least producing torque for rotating the motor, while switches, such as semiconductor switches, of the variable frequency drive are not being switched on and off, or not being modulated, and hence the motor is not being driven by the variable frequency drive by alternating current/voltage. In addition to the standby mode, the variable frequency drive can be in an off-mode, where the variable frequency drive is disconnected from the electrical energy source, and in an operation mode, during which the variable frequency drive is connected to the electrical energy source and the variable frequency drive is driving the motor, i.e., the motor is rotating or at least torque is produced therein. In this invention, it has been noticed that during the standby mode there is a DC-like standby voltage at the output of the variable frequency drive, which is thus also present at the motor phases of the motor, or particularly between one or several of the motor phases and the ground potential. This standby voltage is thus applied to the motor during the standby mode of the variable frequency drive and this standby voltage is thus measured by the monitoring device. Because of the presence of such standby voltage, the monitoring device itself does not need to apply any voltage to the motor in order to measure the winding insulation condition of the motor. Instead, the monitoring device utilizes the standby voltage of the variable frequency drive and thus the invention results in reduced energy consumption by the device. In other words, the monitoring device is configured to not apply a voltage, especially not between at least one of the motor phases and a frame of the motor, but is rather configured to utilize the standby voltage applied by the variable frequency drive and in particular to measure such standby voltage, applied by the variable frequency drive during the standby mode of the variable frequency drive.

For example, the signal indicative of the standby mode may be received or obtained via a connection, such as communication and/or electrical connection, between an input/output port or relay of the variable frequency drive and the monitoring device (may in some cases be transmitted within the variable frequency drive if the device is integrated thereto), such as related to an input/output port or relay indicating the status of the variable frequency drive. The status may be, for example, however, not limited to, "VFD ready" in the standby mode, or "Motor running" in the operation mode.

According to an embodiment of the invention, the monitoring device is further configured to close the voltage measuring circuit, such as by a control unit that may comprise processors, e.g. microprocessors and a memory unit, said control unit connected to or comprised within the monitoring device, to start measuring the standby voltage automatically after the variable frequency drive is determined to be in the standby mode and to open the voltage measuring circuit to stop measuring the standby voltage automatically once the variable frequency drive is determined to be in a mode other than the standby mode. Such embodiment enables automated monitoring of the winding insulation condition of a motor thus further reducing the need of manual work by an operator. In some embodiments, the control unit may, in addition, or alternatively, comprise a comparator for comparing the measured standby voltage and the predetermined threshold values.

According to a further embodiment of the invention, the monitoring device is further configured, such as by a control unit, to compare the measured standby voltage to a predetermined threshold value and to perform at least one action based on the comparison result. This provides further automatization of the monitoring process, increasing efficiency of the system.

According to an embodiment of the invention, the monitoring device is further configured, such as by a control unit, to activate a notification unit when the measured standby voltage drops below a first threshold value, said notification unit configured to issue a warning indicating deteriorated condition of the winding insulation of the motor. The automated warning procedure further automates the monitoring process, reducing the need of manual analysis and interpretation of the measurement data, thus simplifying the handling of the monitoring system as well as decision making. Providing a warning based on the measured standby voltage value allows to efficiently plan for replacement of pre-emptive drying of the motor without causing disruptive downtimes of equipment.

According to an embodiment of the invention, the monitoring unit is further configured, such as by a control unit, to activate a dryer when the measured standby voltage drops below a second threshold value, said dryer configured to dry the winding insulation of the motor. The automated control of the dryer further reduces downtime of equipment as well as need for manual labour. Due to automated drying of the winding insulation of the motor, the need to replace the motor can be avoided, thus reducing manual labour as well as reducing spare parts inventory kept on stock, thus overall reducing maintenance and advance investment costs. The automated integrated drying provided by the invention further provides not just predictive but also pre-emptive maintenance thus reducing sudden and unexpected downtimes and simplifying the maintenance procedure.

According to an embodiment of the invention, the monitoring unit is further configured, such as by a control unit, to deactivate the dryer when the measured standby voltage exceeds a third threshold value. Automated deactivation of the dryer optimizes the time when the dryer is active, thus reducing energy consumption.

According to an embodiment of the invention, the monitoring unit is further configured, such as by a control unit, to open the voltage measuring circuit once the measured standby voltage value exceeds the third threshold value.

According to an embodiment of the invention, the monitoring device is further configured to monitor winding insulation condition of a plurality of motors, motor phases of which are connected to one or more variable frequency drives, said monitoring device comprising a plurality of voltage measuring circuits, each configured to measure a standby voltage between at least one of the motor phases and a frame of one of the plurality of motors, respectively, while the variable frequency drive, connected to the respective on of the plurality of motors, is in the standby mode, the standby voltage being indicative of the winding insulation condition of said motor and where said motor is connected to said variable frequency drive. The possibility to simultaneously and/or alternatively monitor a plurality of motors with a single monitoring device further increases system efficiency and decreases the costs as well as amount of space needed for the monitoring equipment.

The monitoring device according to the invention can be connected to the motor phases of the motor by separate cables, or it can be directly installed to a power bus of a motor control centre. Alternatively, the monitoring device can be installed directly into the variable frequency drive unit. Moreover, the monitoring device can also be connected to a broader automation system that could be connected to a plurality of monitoring devices and thus the automation system could be configured to receive data from the plurality of monitoring devices as well as control the plurality of monitoring devices and/or any notification units, dryers or any other devices connected to the monitoring devices or the automation system. Thus, the monitoring device can be compact and easily integrated in the existing motor arrangements.

According to an embodiment of the invention, the system further comprises a notification unit configured to issue a warning indicating deteriorated condition of the winding insulation of the motor when the measured standby voltage drops below a first threshold value. In addition to the earlier mentioned benefits of a notification unit providing warnings, integrating the notification unit within the system provides for simplified and potentially more compact installation of the monitoring system.

According to an embodiment of the invention, the system further comprises a dryer for drying winding insulation of the motor, said dryer configured to be activated when the measured standby voltage drops below a second threshold value. In addition to the earlier mentioned benefits of a dryer, integrated dryer within the system provides for simplified and potentially more compact installation of the monitoring system.

According to an embodiment of the invention, the method further comprises stopping the measuring at the latest once the variable frequency drive is determined to be in a mode other than the standby mode.

According to an embodiment of the invention, the method further comprises comparing the measured standby voltage to a predetermined threshold value, and performing at least one action based on the comparison result.

According to an embodiment of the invention, the at least one action performed in the method comprises one or more of the following: issuing a warning indicating deteriorated condition of the winding insulation, issuing a critical warning indicating severely deteriorated condition of the winding insulation, removing one or both of the warnings, activating heating of the winding insulation, deactivating heating, stopping the measuring by the monitoring device, enabling and/or disabling starting of the variable frequency drive. In a preferred embodiment, the at least one action may comprise at least issuing a warning indicating deteriorating condition of the winding insulation.

The previously presented considerations concerning the various embodiments and the benefits of the monitoring device are also applicable, mutatis mutan-dis, to the system and the method defined earlier, and vice versa, as would be appreciated by a skilled person.

The novel features which are considered as characteristic of the invention are set forth in particular in the appended claims. The invention itself, however, both as to its construction and its method of operation will be best understood from the following description of specific example embodiments when read in connection with the accompanying drawings.

### Brief description of the drawings

Embodiments of the invention are described below in more detail with reference to the accompanying drawings, in which
Figs. 1A and 1B show two schematics with electrical connections of a system according to two embodiments of the invention,
Fig. 2 shows a schematic of a typical measurement of a standby voltage of the variable frequency drive according to an embodiment of the invention,
Fig. 3 shows a schematic with electrical connections of a system according to another embodiment of the invention,
Fig. 4 shows a schematic with electrical connections of a system according to an embodiment of the invention,
Fig. 5 shows a flow chart of a method according to the invention,
Fig. 6 shows a flow chart of a method according to an embodiment of the invention.
Fig. 7 shows an example of a step-by-step flow chart of a method according to an embodiment of the invention.

### Detailed description

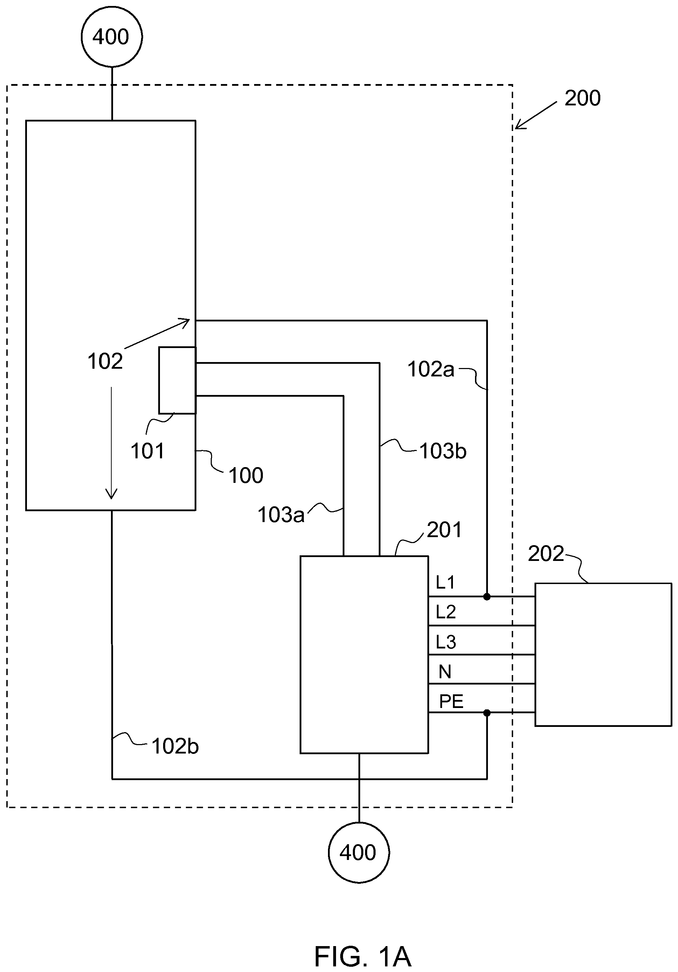

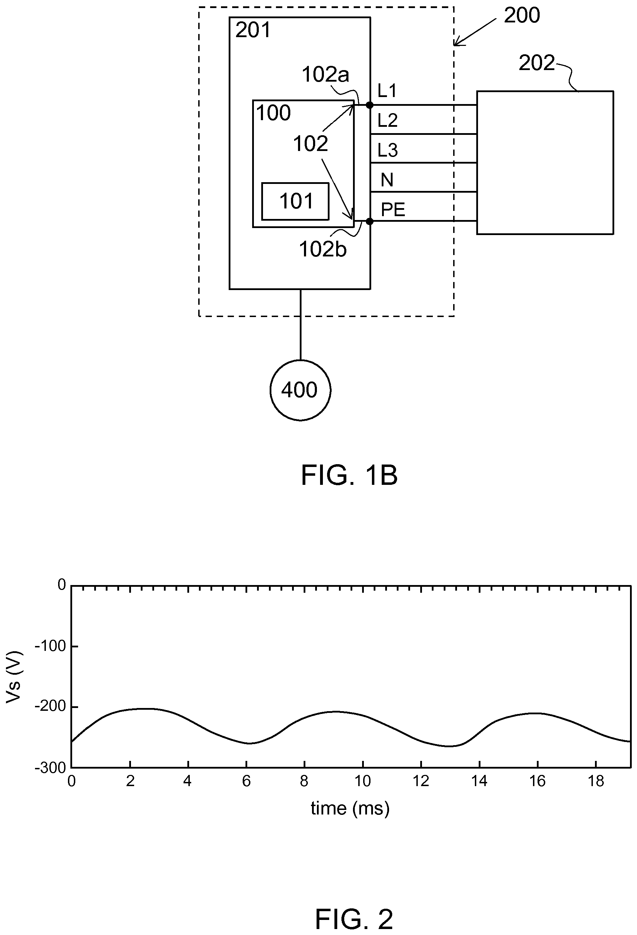

Figures 1A and 1B show two schematics of a system 200 according to the invention for monitoring winding insulation condition of an electric motor 202, motor phases of which are connected to a variable frequency drive 201. The motor 202 can be any electric motor, for example, a three-phase induction motor or a single phase or synchronous motor. The system 200 comprises a monitoring device 100, connected to, as in Fig. 1A, or comprised within, as in Fig. 1B, the variable frequency drive 201 for receiving or obtaining a signal indicative of the standby mode, and the variable frequency drive 201, which, in figures 1A and 1B, is connected to the motor 202 via 3 phase electrical lines L1, L2, L3, referred to as motor phases of the motor 202 throughout the application, as well as a neutral line N and a ground (protected earth) line PE. The monitoring device 100, in figures 1A and 1B, or more specifically the positive terminal of the monitoring device 100, is connected to the first motor phase L1 of the motor 202. In figures 1A and 1B, said connection is illustrated as an electrical line 102a. The monitoring device 100 could be instead connected to any of the motor phases of the motor 202. The monitoring device 100 is further connected via an electrical line 102b to the frame of the motor 202 or the ground line PE between the variable frequency drive 201 and the motor 202. Together, electrical lines 102a and 102b form a standby voltage measuring circuit 102 configured to measure a standby voltage from the variable frequency drive 201 when the variable frequency drive 201 is in a standby mode. In some embodiments, the system 200 may comprise also the motor 202.

The winding insulation condition of a motor 202 can be evaluated by the resistance of the winding insulation. In addition, the standby voltage is also indicative of the winding insulation condition of the motor 202. In particular, humidity and exposure to water deteriorates winding insulation condition, resulting in reduction of insulation resistance, which in turn leads to reduced standby voltage between the variable frequency drive 201 and the motor 202.

The standby mode of a variable frequency drive 201 is defined as a mode where the variable frequency drive 201 is supplied with power from an electrical energy source 400, such as the grid or a battery or other power supply, to be ready for operation while the variable frequency drive 201 is switched off and hence the motor 202 is not being driven by the variable frequency drive 201, i.e., the motor 202 does not produce torque. In addition to the standby mode, the variable frequency drive 201 can be in an off-mode, where the variable frequency drive 201 is disconnected from the electrical energy source 400, and in an operation mode, during which the variable frequency drive 201 is connected to the electrical energy source 400 and the variable frequency drive 201 is driving the motor 202, i.e., the motor 202 is rotating. In this invention, it has been noticed that during the standby mode there is a DC-like standby voltage at the output of the variable frequency drive 201, which is thus also present at the motor phases of the motor 202. The DC-like standby voltage may be a pulsating DC waveform, as illustrated in figure 2. This standby voltage is thus applied to the motor 202 during the standby mode of the variable frequency drive 201 and this standby voltage is thus measured by the monitoring device 100. Because of the presence of such standby voltage, the monitoring device 100 itself does not need to apply any voltage to the motor 202. The amplitude of the standby voltage could be about 200-350 VDC. The exact standby voltage amplitude, however, depends on the specific variable frequency drive 201. As an example, the amplitude of the standby voltage could be 260 VDC. The polarity is such that the potential of any of the motor phases connected to the variable frequency drive 201 in the standby mode is lower than the ground potential and thus also lower than the potential at the frame of the electric motor 202. The current between the variable frequency drive 201 and the motor 202 during the standby mode is negligible.

Figure 2 illustrates an example of a typical time dependent measurement of the standby voltage (Vs). In figure 2, the standby voltage is around -243 VDC with a fluctuation at around 150 Hz frequency, obtained for a variable frequency drive 201 with input voltage of 230 / 400 V with input frequency of 50 Hz. The frequency of the standby voltage is thus approximately three times that of the network. The standby voltage measurement data shown in figure 2 was obtained when using a three phase variable frequency drive 201 with rated input values: 380-480 V, 15.4 A, 48-63 Hz and with rated output values: voltage between 0 and the input voltage, 15.4 A, 0-500 Hz. The variable frequency drive 201 may, however, be three phase or single phase at the input and/or the output. An example of typical values for an electric motor 202 is 2.2 kW, 50 Hz, 230/400 V, 5.9/5.1 A, 955 rpm, and power factor of 0.75. Another example of typical values for an electric motor 202 could be 2.6 kW, 60 Hz, 265/460V, 8.7/5.0 A, 1150 rpm, and a power factor of 0.77. Various different electrical motors can also be used. Electric motor 202 may also be a three phase or a single phase motor.

Figures 1A and 1B also show the monitoring device 100 according to the invention for monitoring winding insulation condition of an electric motor 202, motor phases of which are connected to a variable frequency drive 201. The monitoring device 100 could be external to and electrically connected to the variable frequency drive 201 and the motor 202 as illustrated in figure 1A. Alternatively, as shown in figure 1B, the monitoring device 100 could be integrated or insertable, for example, as an expansion card or device, into the variable frequency drive 201 unit. The monitoring device 100 according to the invention is configured, by, for example, standby mode determining means, or a processing unit 101, to determine whether the variable frequency drive 201 is in the standby mode based on a signal received or obtained from the variable frequency drive 201. The processing unit 101 could be a shared processing unit 101, shared by the monitoring device 100 and the variable frequency drive 201, especially in the case shown in figure 1B where the monitoring device 100 is integrated within the variable frequency drive 201. Moreover, the processing unit 101 could be a shared processing unit part of a broader automation system, such that the same processing unit can be used with a plurality of monitoring devices and variable frequency drives. Electrical lines 103a, 103b, shown in figure 1A, provide a circuit for communicating a signal from which the standby mode or the operation mode of the variable frequency drive 201 can be determined. Such circuit is not illustrated in figure 1B, however, since monitoring device 100 is integrated within the variable frequency drive 201, the monitoring device 100 is electrically connected to the variable frequency drive 201. The monitoring device 100 is configured, such as by the voltage measuring circuit 102, to measure the standby voltage between at least one of the motor phases and the frame of the motor 202 or the ground line PE between the variable frequency drive 201 and the motor 202 while the variable frequency drive 201 is determined to be in the standby mode.

The monitoring device 100 can be made as a separate product configured to be connectable to an electrical energy source 400, such as the grid or a battery or other power supply, to a variable frequency drive 201, and to at least one of the motor phases of the motor 202 as well as the frame of the motor 202 or the ground line PE. The variable frequency drive 201 can be connectable to an electrical energy source 400 and to the motor 202. Alternatively, the monitoring device 100 can be made as an integral part of a system 200 configured to be connectable to a motor 202 as well as to an electrical energy source 400 for supplying power to the monitoring device 100 as well as to the variable frequency drive 201. Furthermore, the monitoring device 100 can be made as a module insertable into the variable frequency drive 201 unit, thus being powered via the electrical energy source 400 connected to the variable frequency drive 201, the monitoring device 100 configured to be connected to at least one of the motor phases of the motor 202 as well as the frame of the motor 202 or the ground line PE via connections inside the variable frequency drive 201. It should be noted that while connections are illustrated as electrical lines resembling cables in figures 1A and 1B as well as figures 3 and 4, all the connections could be implemented in other ways commonly known in the art, such as providing contact points, terminals, or ports to which cables, electrodes or busbars can be connected. In particular, for example, the monitoring device 100 as well as the system 200 can be made as products comprising only input and output contact points, terminals or ports, with no cables coming out from the monitoring device 100 or the system 200. Such cables could be provided separately. Alternatively, the electrical connection lines could be integrated with the monitoring device 100 and/or the system 200.

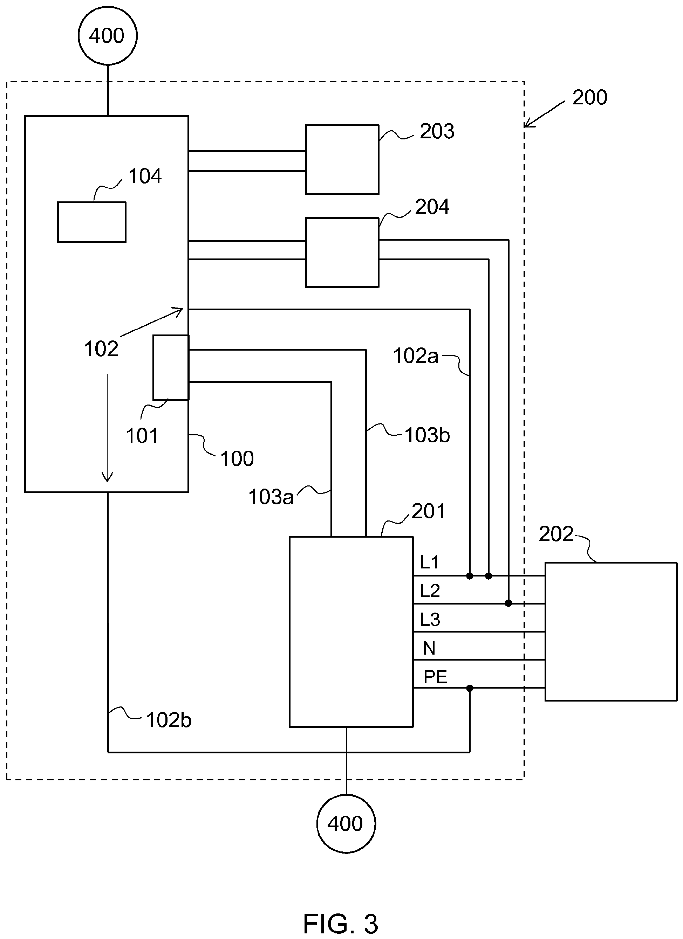

Figure 3 illustrates a schematic of a system 200 according to an embodiment of the invention, where the system 200 of figure 3 is essentially the same as in figure 1A, except that the system 200 of figure 3 further comprises a notification unit 203, a dryer 204 and the monitoring device 100 further comprises a control unit 104. A system 200 according to the invention could comprise, in addition to the features illustrated in figures 1A and 1B, both a notification unit 203 and a dryer 204, or only one of them or neither. The notification unit 203 as well as the dryer 204 or either one of them could be integrated in the monitoring device 100 or could be implemented as separate devices. The control unit 104, similar to the processing unit 101 described earlier, can be integrated in the monitoring device 100, or in the variable frequency drive 201, be a separate device, or be a part of a broader automation system. The control unit can also be a shared unit, shared by the monitoring device 100 and the variable frequency drive 201, and/or by the a broader automation system, such that the same control unit 104 could be used to control a plurality of monitoring devices 104 as well as any additional devices. Figure 3 illustrates that the notification unit 203 is electrically connected to the monitoring device 100. The dryer 204 is also illustrated in figure 3 to be electrically connected to the monitoring device 100 as well as to the motor 202. Alternatively, the notification unit 203 and/or the dryer 204 could be electrically connected to the control unit 104 directly.

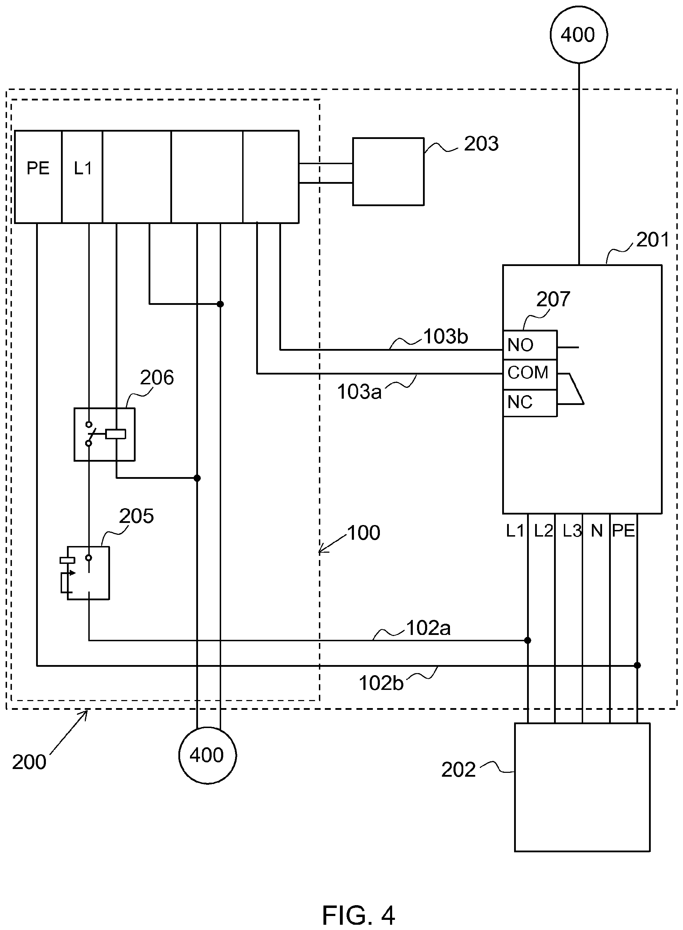

Figure 3 illustrates an embodiment of the invention where a monitoring device 100 further comprises a control unit 104. Similar to the above discussion of figure 1B, where the monitoring device 100 is comprised within the variable frequency drive 201, the same configuration is possible for figure 3 (as well as figure 4). The control unit 104 may comprise a processing unit, e.g., a microprocessor, and a memory unit. Additionally, the control unit 104 may comprise a voltage divider that can be calibrated to convert the measured standby voltage to a voltage range of the control unit 104. The calibration of the voltage divider can be done automatically or manually, or pre-set in advance based on the specification of a variable frequency drive 201. Preferably, the calibration is done such that the maximum voltage of the voltage divider corresponds to the maximum measured standby voltage for the selected variable frequency drive 201, i.e., measured when the motor insulation windings are dry and in good condition, whereas 0 V of the voltage divider corresponds to the 0 V of the measured standby voltage, the remaining voltages between the maximum and the zero being interpolated accordingly. In addition, or alternatively, the control unit 104 may comprise a comparator for comparing the measured standby voltage and the predetermined threshold values. Yet alternatively, the control unit may be one or more relays. The monitoring device 100, or more specifically, e.g., the control unit 104, can be configured to close the voltage measuring circuit 102 to start measuring the standby voltage automatically after the variable frequency drive 201 is determined to be in the standby mode by, for example, the standby mode determining means or the processing unit 101 of the monitoring device 100. The monitoring device 100, or, more specifically, e.g., the control unit 104, can be configured to start the measurement a pre-set amount of time after the motor 202 had been switched off and the variable frequency drive 201 had been put to the standby mode. The shortest pre-set time is defined by the time needed to load the capacitors of the monitoring device 100. For example, the pre-set amount of time after switching off the motor 202 could be 1 second - 20 minutes. Preferably, the pre-set amount of time can be 5 - 20 min. The monitoring device 100 can in addition be configured to open the voltage measuring circuit 102 to stop measuring the standby voltage automatically once the variable frequency drive 201 is determined to be in a mode different than the standby mode, such as, e.g. an operation mode. The measurement can be stopped, as illustrated in figure 4, e.g., by a relay 207 opening a switch in response to the variable frequency drive 201 entering a mode other than the standby mode, in which case, the monitoring device 100 then controls, such as via a control unit 104, the relay 206 to open a switch and thus open the standby voltage measuring circuit. A circuit breaker or a fuse 205 can further be used, as illustrated in figure 4, for overcurrent and short-circuit protection.

According to an embodiment of the invention, the monitoring device 100 can be further configured to compare the measured standby voltage to a predetermined threshold value. The monitoring device 100 can further be configured to perform at least one action based on the comparison result. Examples of actions that can be performed by the control unit 104 can be, e.g., issuing a warning indicating deteriorated condition of the winding insulation, issuing a critical warning indicating severely deteriorated condition of the winding insulation, removing one or both of the warnings, activating heating of the winding insulation, deactivating heating, stopping the measuring by the monitoring device 100, enabling and/or disabling starting of the variable frequency drive 201.

According to an embodiment of the invention, the monitoring device 100 can be configured to activate a notification unit 203 when the measured standby voltage drops below a first threshold value. The first threshold value can be any value lower than the maximum standby voltage measured when the motor 202 is completely dry. The first threshold value can be chosen and adjusted on a case by case basis depending on the application at hand. The first threshold value could be, for example, 70-95% of the maximum standby voltage. In particular, the first threshold value could be, e.g., 95%, 90%, 85%, 80%, 70%. Preferably, the first threshold value could be 80-90% of the maximum standby voltage. As illustrated in figure 3, the notification unit 203 can be connected to the monitoring device 100 via electrical connections. The notification unit 203 can be configured to activate the notification unit 203 when the measured standby voltage drops below a first threshold value. When the notification unit 203 is activated, it issues a warning indicating deteriorated condition of the winding insulation of the motor 202. The warning could be a blinking light, a specific colour light indicator, a digital message displayed on a screen, an audio signal, on any other means commonly known to a skilled person. According to a further embodiment of the invention, there could be a plurality of first threshold values and a plurality of warnings issued at different levels of winding insulation condition, where the control unit 104 would be configured to activate the notification unit 203 for any of such first threshold values.

According to an embodiment of the invention, the monitoring device 100 can be configured to activate a dryer 204 when the measured standby voltage drops below a second threshold value. The second threshold value is lower than the first threshold value. The second threshold value can also be chosen on a case by case basis depending on the application at hand. As an example, the second threshold value could be 30-70% of the maximum standby voltage, however, the second threshold value could be as low as 0% at which point the motor 202 is broken. In particular, the second threshold value could be, e.g., 70%, 60%, 50%, 40%, 30%. The dryer 204 can be configured to heat and dry the winding insulation of the motor 202. As illustrated in figure 3, the dryer 204 can be connected to the monitoring device 100 and to the winding insulation of the motor 202 by connecting to the phases of the motor 202. In this case, the dryer 204 may send direct current impulses through the winding of the motor 202 and cause heating due to resistance between the phases of the motor 202. Alternatively, a separate heating element could be inserted inside or close to the motor 202. During the drying mode, monitoring device 100 may continue measuring the standby voltage. The control unit 104 can be further configured to deactivate the dryer 204 when the measured standby voltage exceeds a third threshold value. The third threshold value is higher than the second threshold value. The third threshold value could be the same as the first threshold value. Just like the first and the second, also the third threshold value can be chosen on a case by case basis depending on the application at hand. When the dryer 204 is deactivated, the monitoring device could be configured to stop measuring the standby voltage at the same time or it could continue to measure the standby voltage until the variable frequency drive 201 is determined to be in a mode other than the standby mode, such as, e.g., an operation mode. The measuring could be done continuously, repeated periodically every 1s, 5s, or some other predefined period of time, or measured continuously for a predefined period of time followed by a break of a predefined length. For example, measurements could be taken continuously for 6 seconds, followed by a break. The break is preferably 5-30 minutes long depending on the application and the circumstances. The data acquired during a single continuous measurement period could be averaged to create a single standby voltage output point. According to an embodiment, the monitoring device 100 can be configured to automatically open the voltage measuring circuit 102, such as by operating the relay 206 shown in figure 4, thus disconnecting the monitoring device 100 from the motor 202 circuit when the variable frequency drive 201 is determined to be in a mode other than the standby mode, such as, e.g., the operation mode. Alternatively, the monitoring device 100 could be configured to open the voltage measuring circuit 102 once the measured standby voltage value exceeds the third threshold value.

According to a further embodiment of the invention, the monitoring device 100 can be configured to disable the starting of the variable frequency drive 201 and thus of the motor 202 when the measured standby voltage drops below the second threshold value. The measuring device 100 could be further configured to enable the starting of the variable frequency drive 201 when the dryer 204 is deactivated and/or when the measured standby voltage exceeds the third threshold value.

According to another embodiment of the invention, the monitoring device 100 can be configured to activate the dryer 204 whenever the variable frequency drive 201 is in the standby mode, even if the measured standby voltage exceeds the second threshold value. In such drying procedure, the direct current applied by the dyer 204 to the motor 202 winding could be lower than the direct current applied in the case when the dryer 204 is activated only once the measured standby voltage drops below the second threshold value.

While the description so far has discussed the situation of the monitoring device 100 and the system 200 monitoring winding insulation condition of a single motor 202, the monitoring device 100 and the system 200, according to an embodiment of the invention, can be configured to monitor winding insulation condition of a plurality of motors 202, motor phases of which being connected to one or more variable frequency drive 201. Thus, a single measuring device 100 can be sufficient to simultaneously and/or alternately monitor winding insulation condition of one or more motors 202. In particular, the monitoring device 100 according to an embodiment comprises a plurality of voltage measuring circuits 102, each configured to measure a standby voltage between at least one of the motor phases and a frame of one of the plurality of motors 202, respectively, while the variable frequency drive 201, connected to the respective one of the plurality of motors, is in the standby mode, the standby voltage being indicative of the winding insulation condition of said motor 202 and where said motor 202 is connected to said variable frequency drive 201. The plurality of motors 202 could be controlled by a single variable frequency drive 201. Alternatively, each one of the plurality of motors 202 can be controlled by a separate variable frequency drive 201. The control unit 104 of the monitoring device 100 could be configured to receive signals indicative of the standby mode of each of the variable frequency drives 201 and thus to start the standby voltage measurement of the respective motor 202 when the standby mode is detected or any predetermined amount of time after determining the standby mode. A combination where some of the plurality of motors 201 are controlled by a single variable frequency drive 201 and some of the plurality of motors 201 are controlled by separate variable frequency drives 201 is also possible. It follows also that a system 200 according to an embodiment of the invention may comprise a plurality of variable frequency drives 201 configured to be connected to a plurality of motors 202.

In some embodiments of the invention, the monitoring device can be configured to be connected to the motor phases of the motor directly, such as by separate cables. Alternatively, the monitoring device can be configured to be installed inside a motor control centre of an electric motor or motors, the monitoring device being connected to a power bus of the motor control centre, which can then in turn be connected to the motor phases of the motor. Moreover, the monitoring device 100 can also be connected to a broader automation system that could be further connected to a plurality of monitoring devices and thus the automation system can be configured to receive data from the plurality of monitoring devices as well as control the plurality of monitoring devices and/or any notification units, dryers or any other devices connected to the monitoring devices or the automation system. The monitoring device may comprise Modbus protocol for automation and control system integration. Alternatively, measuring and operation data may be transferred via M2M-modem to the monitoring device 100.

The system 200, shown in figure 3, could further comprise relays, for example, between the monitoring device 100 and the notification unit, between the monitoring device 100 and the dryer, between the monitoring device 100 and the variable frequency drive 201, and/or between the monitoring device 100 and the motor 200. Some of the relays 206, 207 are illustrated in figure 4. In addition to the relay 206, figure 4 illustrates a circuit breaker or a fuse 205 between the monitoring unit 100 and the motor 202.

Figure 4 illustrates a schematic of a system 200 according to an embodiment of the invention, similar to those of figure 1 and 3, except that additional relays 206, 207 and a circuit breaker or a fuse 205 are also part of the system. The relay 207 located within the variable frequency drive 201 in figure 3 is shown in an open configuration corresponding to a mode other than the standby mode, such as the operation mode, of the variable frequency drive 201. When the variable frequency drive 201 is switched to the standby mode, the relay 207 switches to a closed configuration thus completing electrical circuit 103 and sending a signal to the monitoring device 100 used for determining that the variable frequency drive 201 is in the standby mode. Such signal could be received and interpreted by, for example, a standby mode determining means or a processor unit 101 forwarding the obtained information to the control unit 104. When it is determined that the variable frequency drive 201 is in the standby mode, the monitoring device 100, or more specifically, e.g., the control unit 104, controls the relay 206 to close thus completing the standby voltage measuring circuit 102 and thus starting the standby voltage measuring. On the other hand, when it is determined that the variable frequency drive 201 is in a mode other than the standby mode, the monitoring device 100 controls the relay 206 to open thus disconnecting the standby voltage measuring circuit 102 and stopping the standby voltage measuring. Naturally, the opposite configuration is also possible, where the relay 207 is in an open configuration when the variable frequency drive 201 is in the standby mode and the relay 207 switches to closed configuration when the variable frequency drive 201 is switched to the operation mode thus sending a signal to the monitoring device 100 that the variable frequency drive 201 is in the operation mode. The relay 206 and/or the circuit breaker 205 may be located inside the monitoring device 100, as illustrated in figure 4, i.e., the monitoring device 100 may comprise the relay 206 and/or the circuit breaker 205.

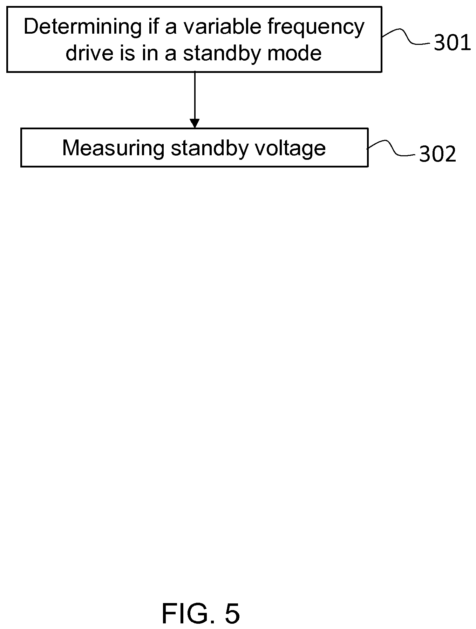

A method for monitoring winding insulation condition of a motor 202, motor phases of which are connected to a variable frequency drive 201, according to the invention is illustrated in figure 5. The method comprises determining 301, such as, e.g., by a monitoring device 100, if a variable frequency drive 201 is in a standby mode, or more specifically receiving or obtaining 301, by a monitoring device 100, a signal indicative of a standby mode of the variable frequency drive 201. The monitoring device 100 used in the method may be, according to some embodiments of the invention, as explained in connection to figures 1-3 earlier. If the variable frequency drive 201 is determined to be in the standby mode, then a standby voltage is measured 302 between at least one of the motor phases and the frame of the motor 202 with the monitoring device 100, such as, e.g., by utilizing the voltage measuring circuit 102, while the variable frequency drive 201 is determined to be in the standby mode. Since the standby voltage is indicative of the winding insulation condition of the motor 202, monitoring the standby voltage provides a way to monitor winding insulation condition of a motor 202. It is thus emphasized that the measurement by the monitoring device 100 is only started after the variable frequency drive 201 is determined to be in the standby mode. In some embodiments, the method further comprises stopping the measuring at the latest once the variable frequency drive 201 is determined to be in a mode other than the standby mode so that the measurement is only performed while the variable frequency drive 201 is in the standby mode. However, it should be noted that the measurement could also be stopped earlier. For example, the monitoring device 100 could be configured to stop the measurement after a certain period of time from the start of the measurement has elapsed or once a certain threshold value is reached.

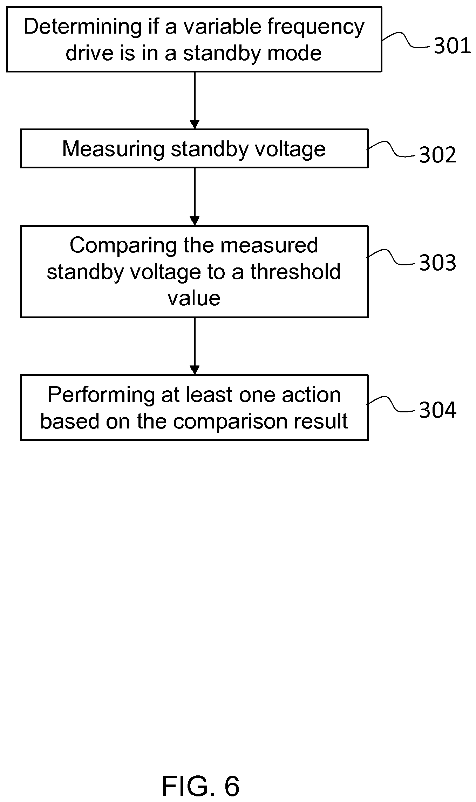

Figure 6 illustrates the method of figure 5 further comprising additional steps of comparing 303 the measured standby voltage to a threshold value, and performing 304 at least one action based on the comparison result. The at least one action can be selected from at least the following: issuing a warning indicating deteriorated condition of the winding insulation, issuing a critical warning indicating severely deteriorated condition of the winding insulation, removing one or both of the warnings, activating heating of the winding insulation, deactivating heating, stopping the measuring by the monitoring device 100, enabling and/or disabling starting of the variable frequency drive 201.

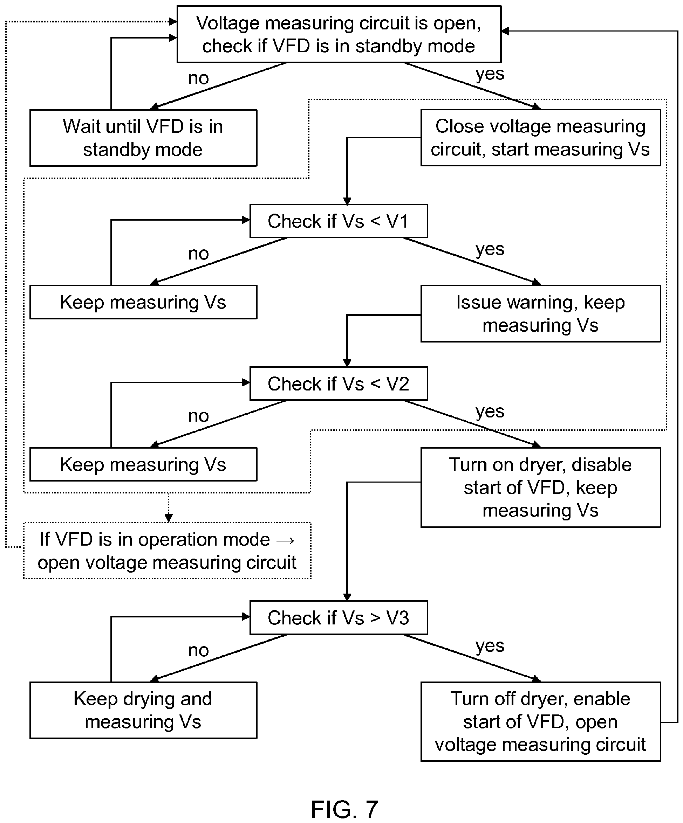

Figure 7 illustrates an example of a step-by-step flow chart of the method according to an embodiment of the invention. In order to perform the method, initially the monitoring device 100 is connected to an electrical energy source 400, to the variable frequency drive 201, to at least one of the motor phases of the variable frequency drive 201 and to the frame or ground of the motor 202. Furthermore, for the method of figure 7, the monitoring device 100 is connected to a notification unit 203 and a dryer 204, which is further connected to the motor 202. The steps of connecting the monitoring device 100 to the notification unit 203 and/or the dryer 204 might be unnecessary if the notification unit 203 and/or the dryer 204, respectively, are integrated within the monitoring device 100. Similarly, if an integrated system 200 is provided instead of the monitoring device, it may be sufficient to connect the system 200 to an electrical energy source 400 and to the motor 202 as well as connect the dryer 204 of the system 202 to the winding of the motor 202.

Once all the needed connections are implemented, the method of figure 7 may start with the voltage measuring circuit 102 being in open-circuit state, whereas the variable frequency drive 201 (shortened to VFD in figure 7) may be in an operation mode or in a standby mode. The method according to the embodiment of figure 7 thus starts by checking with the monitoring device 100, or more particularly by, for example, standby mode determining means or a processing unit 101, whether the variable frequency drive 201 is in the standby mode. If the variable frequency drive 201 is not in the standby mode, the monitoring device 100 or the system 200 keeps on checking and waiting until the variable frequency drive 201 is determined to be in the standby mode. The checking and waiting could be done continuously. Alternatively, the checking and waiting could be repeated periodically every 1 s, 5s, 1 min, 5 min, or some other predefined period of time. Alternatively, the checking could be performed on demand. For example, the variable frequency drive 201 may comprise a relay 207 that connects the electrical circuit 103 when the variable frequency drive 201 enters the standby mode and thus sends a signal to the monitoring device 100 that the variable frequency drive 201 is now in the standby mode. Once it is determined that the variable frequency drive 201 is in the standby mode, the monitoring device 100 closes, or more specifically sends a command to close, the voltage measuring circuit 102 thus starting the standby voltage measurement (labelled as Vs in figure 7).

After obtaining a measurement of the standby voltage, the monitoring device 100 compares the measured standby voltage Vs to the first threshold value V1, where the measuring device 100 may store, such as in a memory of the monitoring device 100 or more specifically in a memory of the control unit 104 of the measuring device 100, a set of threshold values provided to the monitoring device 100 in advance. If the standby voltage Vs is higher than the first threshold value V1, the measurements and comparisons to the first threshold value continue. If, however, the standby voltage Vs is lower than the first threshold value V1, the monitoring device 100 sends a command to the notification unit 203 to issue a warning indicating a deteriorated winding insulation condition. In the meantime, the measurements continue, although now the standby voltage is compared to the second threshold value. The phrase "keep measuring" in figure 7 should be understood to mean that the measurement procedure should be repeated. The measuring could be done continuously, repeated periodically every 1s, 5s, or some other predefined period of time, or measured continuously for a predefined period of time followed by a break of a predefined length. For example, measurements could be taken continuously for 6 seconds, followed by a break. The break is preferably 5-30 minutes long depending on the application and the circumstances. The data acquired during a single continuous measurement period could be averaged to create a single standby voltage output point.

If the standby voltage Vs is higher than the second threshold value V2, the measurements and comparisons to the second threshold value continue. If, however, the standby voltage Vs is lower than the second threshold value V2, the monitoring device 100 sends a command to the dryer 204 to turn on the drying of the winding insulation of the motor 202. Additionally, the control unit 104 may disable the start function of the variable frequency drive 201 so that the variable frequency drive 201 and the motor 202 cannot be started while the winding insulation condition is bad and the drying is being carried out.

During the drying of the winding insulation of the motor 202, the measurement of the standby voltage Vs may continue and a comparison to the third threshold value V3 may be carried out. If the standby voltage Vs is lower than the third threshold value V3, the measurements and comparisons to the third threshold value continue. If, however, the standby voltage Vs is higher than the third threshold value V3, the monitoring device 100 sends a command to turn off the dryer 204 and, if the start function of the variable frequency drive 201 had been earlier disabled, to enable the start function of the variable frequency drive 201. Furthermore, according to the embodiment of figure 7, the monitoring device sends a command to open the voltage measuring circuit 102 thus stopping the measurements and returning the process to the top of the flow chart of figure 7.

The dotted polygon enclosing part of the steps in the flow chart of figure 7 indicates that if during any of these steps it is determined that the variable frequency drive 201 is being switched to the operation mode or to the off-mode, in that case the control unit 104 immediately sends a command to open the voltage measuring circuit 102 and stop the standby voltage measurement, thus returning the process to the top of the flow chart of figure 7.

It should be noted that while the figure 7 described above includes the features of a notification unit 203 and a dryer 204, such features, as described throughout the application, are not necessary to the invention and as such the method steps shown in figure 7 can be adapted accordingly. According to one preferred implementation of the invention, the method comprises at least the steps starting from the top of figure 7 until but excluding the step of turning on a dryer 204, i.e., the method could be performed without the steps involving the dryer 204.

## Claims

1. A monitoring device (100) for monitoring winding insulation condition of an electric motor (202), motor phases of which are connected to a variable frequency drive (201), **characterized in that** the monitoring device (100) is configured to:
receive or obtain a signal indicative of a standby mode of the variable frequency drive (201), and
measure a standby voltage, being applied by the variable frequency drive (201) during the standby mode, between at least one of the motor phases and a frame of the motor (202) while the variable frequency drive (201) is determined to be in the standby mode, the standby voltage being indicative of the winding insulation condition.

2. A monitoring device (100) according to claim 1, further configured to close a voltage measuring circuit (102) to start measuring the standby voltage automatically after the variable frequency drive (201) is determined to be in the standby mode and to open the voltage measuring circuit (102) to stop measuring the standby voltage automatically once the variable frequency drive (201) is determined to be in a mode other than the standby mode.

3. A monitoring device (100) according to claim 2, further configured to compare the measured standby voltage to a predetermined threshold value and to perform at least one action based on the comparison result.

4. A monitoring device (100) according to claim 2 or 3, further configured to activate a notification unit (203) when the measured standby voltage drops below a first threshold value, said notification unit (203) configured to issue a warning indicating deteriorated condition of the winding insulation of the motor (202).

5. A monitoring device (100) according to any of claims 2-4, further configured to activate a dryer (204) when the measured standby voltage drops below a second threshold value, said dryer (204) configured to dry the winding insulation of the motor (202).

6. A monitoring device (100) according to claim 5, further configured to deactivate the dryer (204) when the measured standby voltage exceeds a third threshold value.

7. A monitoring device (100) according to claim 6, configured to open the voltage measuring circuit (102) once the measured standby voltage value exceeds the third threshold value.

8. A monitoring device (100) according to any of claims 1-7, further configured to monitor winding insulation condition of a plurality of motors (202), motor phases of which are connected to one or more variable frequency drives (201), said monitoring device (100) comprising a plurality of voltage measuring circuits (102), each configured to measure a standby voltage between at least one of the motor phases and a frame of one of the plurality of motors (202), respectively, while the variable frequency drive (201), connected to the respective one of the plurality of motors, is in the standby mode, the standby voltage being indicative of the winding insulation condition of said motor (202) and where said motor (202) is connected to said variable frequency drive (201).

9. A system (200) for monitoring winding insulation condition of a motor (202), motor phases of which are connected to a variable frequency drive (201), said system comprising:
- a monitoring device (100) according to any of claims 1-8 connected to or comprised within the variable frequency drive (201) for receiving or obtaining a signal indicative of the standby mode, and
- the variable frequency drive (201) configured to be connected to the motor phases of the motor (202),
wherein the monitoring device (100) is configured to be connected to at least one of the motor phases as well as to the frame of the motor (202) to measure the standby voltage applied by the variable frequency drive (201) between the at least one of the motor phases of the motor (202) and the frame of the motor (202) when the variable frequency drive (201) is in the standby mode.

10. A system (200) according to claim 9, further comprising a notification unit (203) configured to issue a warning indicating deteriorated condition of the winding insulation of the motor (202) when the measured standby voltage drops below a first threshold value.

11. A system (200) according to claims 9 or 10, further comprising a dryer (204) for drying winding insulation of the motor (202), said dryer (204) configured to be activated when the measured standby voltage drops below a second threshold value.

12. A method for monitoring winding insulation condition of a motor (202), motor phases of which are connected to a variable frequency drive (201), **characterized in that** the method comprises:
- receiving or obtaining (301), by a monitoring device (100), a signal indicative of a standby mode of the variable frequency drive (201), and
- measuring (302) a standby voltage, being applied by the variable frequency drive (201) during the standby mode, between at least one of the motor phases and the frame of a motor (202) with the monitoring device (100), while the variable frequency drive (201) is determined to be in the standby mode, the standby voltage being indicative of the winding insulation condition of the motor (202).

13. A method according to claim 12, further comprising stopping the measuring at the latest once the variable frequency drive (201) is determined to be in a mode other than the standby mode.

14. A method according to claim 13, further comprising:
- comparing (303) the measured standby voltage to a predetermined threshold value, and
- performing (304) at least one action based on the comparison result.

15. A method according to claim 14, wherein the at least one action comprises one or more of the following: issuing a warning indicating deteriorated condition of the winding insulation, issuing a critical warning indicating severely deteriorated condition of the winding insulation, removing one or both of the warnings, activating heating of the winding insulation, deactivating heating, stopping the measuring by the monitoring device (100), enabling and/or disabling starting of the variable frequency drive (201).

## Patentansprüche

1. Überwachungsvorrichtung (100) zum Überwachen eines Wicklungsisolierungszustands eines Elektromotors (202), dessen Motorphasen mit einem Frequenzumrichter (201) verbunden sind, **dadurch gekennzeichnet, dass** die Überwachungsvorrichtung (100) konfiguriert ist zum:
Empfangen oder Erhalten eines Signals, das für einen Standby-Modus des Frequenzumrichters (201) indikativ ist, und
Messen einer Standby-Spannung, die während des Standby-Modus durch den Frequenzumrichter (201) angelegt wird, zwischen mindestens einer der Motorphasen und einem Rahmen des Motors (202), während bestimmt wird, dass sich der Frequenzumrichter (201) im Standby-Modus befindet, wobei die Standby-Spannung für den Wicklungsisolierungszustand indikativ ist.

2. Überwachungsvorrichtung (100) nach Anspruch 1, die ferner konfiguriert ist, um einen Spannungsmesskreis (102) zu schließen, um das Messen der Standby-Spannung automatisch zu starten, nachdem bestimmt wurde, dass sich der Frequenzumrichter (201) im Standby-Modus befindet, und um den Spannungsmesskreis (102) zu öffnen, um das Messen der Standby-Spannung automatisch zu stoppen, sobald bestimmt wird, dass sich der Frequenzumrichter (201) in einem anderen Modus als dem Standby-Modus befindet.

3. Überwachungsvorrichtung (100) nach Anspruch 2, die ferner konfiguriert ist, um die gemessene Standby-Spannung mit einem vorbestimmten Schwellenwert zu vergleichen und basierend auf dem Vergleichsergebnis mindestens eine Aktion durchzuführen.

4. Überwachungsvorrichtung (100) nach Anspruch 2 oder 3, die ferner konfiguriert ist, um eine Benachrichtigungseinheit (203) zu aktivieren, wenn die gemessene Standby-Spannung unter einen ersten Schwellenwert fällt, wobei die Benachrichtigungseinheit (203) konfiguriert ist, um eine Warnung auszugeben, die einen verschlechterten Zustand der Wicklungsisolierung des Motors (202) anzeigt.

5. Überwachungsvorrichtung (100) nach einem der Ansprüche 2 bis 4, die ferner konfiguriert ist, um einen Trockner (204) zu aktivieren, wenn die gemessene Standby-Spannung unter einen zweiten Schwellenwert fällt, wobei der Trockner (204) konfiguriert ist, um die Wicklungsisolierung des Motors (202) zu trocknen.

6. Überwachungsvorrichtung (100) nach Anspruch 5, die ferner konfiguriert ist, um den Trockner (204) zu deaktivieren, wenn die gemessene Standby-Spannung einen dritten Schwellenwert überschreitet.

7. Überwachungsvorrichtung (100) nach Anspruch 6, die konfiguriert ist, um den Spannungsmesskreis (102) zu öffnen, sobald der gemessene Standby-Spannungswert den dritten Schwellenwert überschreitet.

8. Überwachungsvorrichtung (100) nach einem der Ansprüche 1 bis 7, die ferner konfiguriert ist, um den Wicklungsisolierungszustand einer Vielzahl von Motoren (202) zu überwachen, deren Motorphasen mit einem oder mehreren Frequenzumrichtern (201) verbunden sind, wobei die Überwachungsvorrichtung (100) eine Vielzahl von Spannungsmesskreisen (102) umfasst, die jeweils konfiguriert sind, um eine Standby-Spannung zwischen mindestens einer der Motorphasen und einem Rahmen eines der Vielzahl von Motoren (202) zu messen, während sich der Frequenzumrichter (201), der mit dem jeweiligen der Vielzahl von Motoren verbunden ist, im Standby-Modus befindet, wobei die Standby-Spannung für den Wicklungsisolierungszustand des Motors (202) indikativ ist und wobei der Motor (202) mit dem Frequenzumrichter (201) verbunden ist.

9. System (200) zum Überwachen eines Wicklungsisolierungszustands eines Motors (202), dessen Motorphasen mit einem Frequenzumrichter (201) verbunden sind, das System umfassend:
- eine Überwachungsvorrichtung (100) nach einem der Ansprüche 1 bis 8, die mit dem Frequenzumrichter (201) verbunden oder darin umfasst ist, zum Empfangen oder Erhalten eines Signals, das für den Standby-Modus indikativ ist, und
- den Frequenzumrichter (201), der konfiguriert ist, um mit den Motorphasen des Motors (202) verbunden zu werden,
wobei die Überwachungsvorrichtung (100) konfiguriert ist, um mit mindestens einer der Motorphasen sowie mit dem Rahmen des Motors (202) verbunden zu werden, um die durch den Frequenzumrichter (201) angelegte Standby-Spannung zwischen der mindestens einen der Motorphasen des Motors (202) und dem Rahmen des Motors (202) zu messen, wenn sich der Frequenzumrichter (201) im Standby-Modus befindet.

10. System (200) nach Anspruch 9, ferner umfassend eine Benachrichtigungseinheit (203), die konfiguriert ist, um eine Warnung auszugeben, die einen verschlechterten Zustand der Wicklungsisolierung des Motors (202) anzeigt, wenn die gemessene Standby-Spannung unter einen ersten Schwellenwert fällt.

11. System (200) nach den Ansprüchen 9 oder 10, ferner umfassend einen Trockner (204) zum Trocknen der Wicklungsisolierung des Motors (202), wobei der Trockner (204) konfiguriert ist, um aktiviert zu werden, wenn die gemessene Standby-Spannung unter einen zweiten Schwellenwert fällt.

12. Verfahren zum Überwachen eines Wicklungsisolierungszustands eines Motors (202), dessen Motorphasen mit einem Frequenzumrichter (201) verbunden sind, **dadurch gekennzeichnet, dass** das Verfahren umfasst:
- Empfangen oder Erhalten (301), durch eine Überwachungsvorrichtung (100), eines Signals, das für einen Standby-Modus des Frequenzumrichters (201) indikativ ist, und
- Messen (302) einer Standby-Spannung, die durch den Frequenzumrichter (201) während des Standby-Modus angelegt wird, zwischen mindestens einer der Motorphasen und dem Rahmen eines Motors (202) mit der Überwachungsvorrichtung (100), während bestimmt wird, dass sich der Frequenzumrichter (201) im Standby-Modus befindet, wobei die Standby-Spannung für den Wicklungsisolierungszustand des Motors (202) indikativ ist.

13. Verfahren nach Anspruch 12, ferner umfassend das Stoppen des Messens spätestens sobald bestimmt wird, dass sich der Frequenzumrichter (201) in einem anderen Modus als dem Standby-Modus befindet.

14. Verfahren nach Anspruch 13, ferner umfassend:
- Vergleichen (303) der gemessenen Standby-Spannung mit einem vorbestimmten Schwellenwert, und
- Durchführen (304) mindestens einer Aktion basierend auf dem Vergleichsergebnis.

15. Verfahren nach Anspruch 14, wobei die mindestens eine Aktion eines oder mehrere von Folgendem umfasst: Ausgeben einer Warnung, die einen verschlechterten Zustand der Wicklungsisolierung anzeigt, Ausgeben einer kritischen Warnung, die einen stark verschlechterten Zustand der Wicklungsisolierung anzeigt, Entfernen einer oder beider der Warnungen, Aktivieren der Beheizung der Wicklungsisolierung, Deaktivieren der Beheizung, Stoppen des Messens durch die Überwachungsvorrichtung (100), Aktivieren und/oder Deaktivieren des Startens des Frequenzumrichters (201).

## Revendications

1. Dispositif de surveillance (100) pour surveiller l'état d'isolation des enroulements d'un moteur électrique (202), dont les phases de moteur sont reliées à un variateur de fréquence (201), **caractérisé en ce que** le dispositif de surveillance (100) est configuré pour :
recevoir ou obtenir un signal indicatif d'un mode de veille du variateur de fréquence (201), et
mesurer une tension de veille, étant appliquée par le variateur de fréquence (201) pendant le mode de veille, entre au moins une des phases de moteur et un châssis du moteur (202) tandis que le variateur de fréquence (201) est déterminé comme étant en mode de veille, la tension de veille étant indicative de l'état d'isolation des enroulements.

2. Dispositif de surveillance (100) selon la revendication 1, configuré en outre pour fermer un circuit de mesure de tension (102) afin de commencer à mesurer automatiquement la tension de veille après que le variateur de fréquence (201) a été déterminé comme étant en mode de veille et pour ouvrir le circuit de mesure de tension (102) afin d'arrêter de mesurer automatiquement la tension de veille une fois que le variateur de fréquence (201) a été déterminé comme étant dans un mode autre que le mode de veille.

3. Dispositif de surveillance (100) selon la revendication 2, configuré en outre pour comparer la tension de veille mesurée à une valeur seuil prédéterminée et pour réaliser au moins une action sur la base du résultat de comparaison.

4. Dispositif de surveillance (100) selon la revendication 2 ou 3, configuré en outre pour activer une unité de notification (203) lorsque la tension de veille mesurée tombe en dessous d'une première valeur seuil, ladite unité de notification (203) étant configurée pour émettre un avertissement indiquant un état détérioré de l'isolation des enroulements du moteur (202).

5. Dispositif de surveillance (100) selon l'une quelconque des revendications 2 à 4, configuré en outre pour activer un dispositif de séchage (204) lorsque la tension de veille mesurée tombe en dessous d'une deuxième valeur seuil, ledit dispositif de séchage (204) étant configuré pour sécher l'isolation des enroulements du moteur (202).

6. Dispositif de surveillance (100) selon la revendication 5, configuré en outre pour désactiver le dispositif de séchage (204) lorsque la tension de veille mesurée dépasse une troisième valeur seuil.

7. Dispositif de surveillance (100) selon la revendication 6, configuré pour ouvrir le circuit de mesure de tension (102) une fois que la valeur de tension de veille mesurée dépasse la troisième valeur seuil.

8. Dispositif de surveillance (100) selon l'une quelconque des revendications 1 à 7, configuré en outre pour surveiller l'état d'isolation des enroulements d'une pluralité de moteurs (202), dont les phases de moteur sont reliées à un ou plusieurs variateurs de fréquence (201), ledit dispositif de surveillance (100) comprenant une pluralité de circuits de mesure de tension (102), chacun étant configuré pour mesurer une tension de veille entre au moins une des phases de moteur et un châssis d'un de la pluralité de moteurs (202), respectivement, tandis que le variateur de fréquence (201), relié au moteur respectif de la pluralité de moteurs, est en mode de veille, la tension de veille étant indicative de l'état d'isolation des enroulements dudit moteur (202) et où ledit moteur (202) est relié audit variateur de fréquence (201).

9. Système (200) de surveillance de l'état d'isolation des enroulements d'un moteur (202), dont les phases de moteur sont reliées à un variateur de fréquence (201), ledit système comprenant :
- un dispositif de surveillance (100) selon l'une quelconque des revendications 1 à 8 relié à ou compris dans le variateur de fréquence (201) pour recevoir ou obtenir un signal indicatif du mode de veille, et
- le variateur de fréquence (201) étant configuré pour être relié aux phases de moteur du moteur (202),
dans lequel le dispositif de surveillance (100) est configuré pour être relié à au moins une des phases de moteur ainsi qu'au châssis du moteur (202) afin de mesurer la tension de veille appliquée par le variateur de fréquence (201) entre l'au moins une des phases de moteur du moteur (202) et le châssis du moteur (202) lorsque le variateur de fréquence (201) est en mode de veille.

10. Système (200) selon la revendication 9, comprenant en outre une unité de notification (203) configurée pour émettre un avertissement indiquant un état détérioré de l'isolation des enroulements du moteur (202) lorsque la tension de veille mesurée tombe en dessous d'une première valeur seuil.

11. Système (200) selon les revendications 9 ou 10, comprenant en outre un dispositif de séchage (204) pour sécher l'isolation des enroulements du moteur (202), ledit dispositif de séchage (204) étant configuré pour être activé lorsque la tension de veille mesurée tombe en dessous d'une seconde valeur seuil.

12. Procédé de surveillance de l'état d'isolation des enroulements d'un moteur (202), dont les phases de moteur sont connectées à un variateur de fréquence (201), **caractérisé en ce que** le procédé comprend :
- la réception ou l'obtention (301), par un dispositif de surveillance (100), d'un signal indicatif d'un mode de veille du variateur de fréquence (201), et
- la mesure (302) d'une tension de veille, étant appliquée par le variateur de fréquence (201) pendant le mode de veille, entre au moins une des phases de moteur et le châssis d'un moteur (202) avec le dispositif de surveillance (100), tandis que le variateur de fréquence (201) est déterminé comme étant en mode de veille, la tension de veille étant indicative de l'état d'isolation des enroulements du moteur (202).

13. Procédé selon la revendication 12, comprenant en outre l'arrêt de la mesure au plus tard une fois que le variateur de fréquence (201) est déterminé comme étant dans un mode autre que le mode de veille.

14. Procédé selon la revendication 13, comprenant en outre :
- la comparaison (303) de la tension de veille mesurée à une valeur seuil prédéterminée, et
- la réalisation (304) d'au moins une action sur la base d'un résultat de comparaison.

15. Procédé selon la revendication 14, dans lequel l'au moins une action comprend une ou plusieurs des actions suivantes : l'émission d'un avertissement indiquant un état détérioré de l'isolation des enroulements, l'émission d'un avertissement critique indiquant un état gravement détérioré de l'isolation des enroulements, la suppression d'un ou des deux avertissements, l'activation du chauffage de l'isolation des enroulements, la désactivation du chauffage, l'arrêt de la mesure par le dispositif de surveillance (100), l'autorisation et/ou le blocage du démarrage du variateur de fréquence (201).
